# EUROPEAN PATENT SPECIFICATION

(11) **EP 2 439 789 B1**
(45) Date of publication and mention of the grant of the patent: **26.08.2020**
(21) Application number: 10013379.2
(22) Date of filing: 06.10.2010
(51) Int. Cl.: H01L 31/0687, H01L 31/0735, H01L 31/0304, H01L 31/0312, H01L 31/18

(54) **Inverted multijunction solar cells with group IV/III-V hybrid alloys**
Umgekehrte Multiverbindungssolarzellen mit Gruppe-IV/III-V-Hybridlegierungen
Cellules solaires multi-jonctions inversées avec alliages hybrides de groupe IV/III-V

(43) Date of publication of application: 11.04.2012
(73) Proprietor: SolAero Technologies Corp., Albuquerque, NM 87123 (US)
(72) Inventor: Sharps, Paul, Albuquerque, NM 87112 (US); Newman, Fred, Albuquerque, NM 87108 (US)
(74) Representative: adares Patent- und Rechtsanwälte Reininger & Partner GmbB

(56) References cited:
- EP-A2- 1 798 777
- WO-A1-2010/044978
- GB-A- 2 467 934
- US-A1- 2006 163 612
- US-B1- 6 281 426
- STAN M ET AL: "High-efficiency quadruple junction solar cells using OMVPE with inverted metamorphic device structures", JOURNAL OF CRYSTAL GROWTH, ELSEVIER, AMSTERDAM, NL, vol. 312, no. 8, 1 April 2010 (2010-04-01) , pages 1370-1374, XP007917245, ISSN: 0022-0248, DOI: DOI:10.1016/J.JCRYSGRO.2009.10.059 [retrieved on 2009-11-01]
- KOUVETAKIS J ET AL: "Independently tunable electronic and structural parameters in ternary Group IV semiconductors for optoelectronic applications", 5TH INTERNATIONAL SYMPOSIUM ON ADVANCED SCIENCE AND TECHNOLOGY OF SILICON MATERIALS (JSPS SI SYMPOSIUM),, 10 November 2008 (2008-11-10), pages 1-5, XP007917244,

## Description

### BACKGROUND OF THE INVENTION

### 1. Field of the Invention

The present invention relates to the field of semiconductor devices, and to fabrication processes and devices such as multijunction solar cells based on Group IV/III-V hybrid semiconductor compounds.

### 3. Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. Under high solar concentration (e.g., 500X), commercially available III-V compound semiconductor multijunction solar cells in terrestrial applications (at AM1.5D) have energy efficiencies that exceed 37%. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads become more sophisticated, the power-to-weight ratio of a solar cell becomes increasingly more important, and there is increasing interest in lighter weight, "thin film" type solar cells having both high efficiency and low mass.

Typical III-V compound semiconductor solar cells are fabricated on a semiconductor wafer in vertical, multijunction structures. The individual solar cells or wafers are then disposed in horizontal arrays, with the individual solar cells connected together in an electrical series circuit. The shape and structure of an array, as well as the number of cells it contains, are determined in part by the desired output voltage and current.

Inverted growth processes, such as exemplified in the fabrication of inverted metamorphic multijunction solar cell structures based on III-V compound semiconductor layers, such as described in M.W. Wanlass et al., Lattice Mismatched Approaches for High Performance, III-V Photovoltaic Energy Converters (Conference Proceedings of the 31st IEEE Photovoltaic Specialists Conference, Jan. 3-7, 2005, IEEE Press, 2005), present an important conceptual starting point for the development of future commercial high efficiency solar cells.

M. Stan et al.: "High-efficiency quadruple junction solar cells using OMVPE with inverted metamorphic device structures", Journal of Crystal Growth, vol. 312, No. 8, p. 1370-1374, discloses a monolithically grown, two-terminal, series connected, quadruple junction III-V solar cell, the epitaxial layers of which were grown using organometallic vapor phase epitaxy in an inverted order.

WO 2010/044978 A1, US 2006/163612 A1, and J. Kouvetakis et al.: "Independently tunable electronic and structural parameters in ternary Group IV semiconductors for optoelectronic applications", The 5th International Symposium on Advanced Science and Technology of Silicon Materials (JSPS Si Symposium), Nov. 10-14, 2008, disclose methods for fabricating Si-Ge-Sn alloy semiconductors on Ge buffered Si substrates. The publication describes how the direct band gap of these semiconductors can be tuned, in particular from 0.8-1.4 eV.

EP 17 987 77 A2 describes methods for producing multi-junction solar cells with double heterojunctions.

GB 2467934 A discloses multi-junction solar cells made of epitaxially grown SiGe layers lattice matched to a GaAs substrate. US 6,281,426 B1 discloses multi-junction solar cells comprising multiple semiconductor cells deposited on a GaAs or Ge substrate, the semiconductor cells being made of various group III-V materials.

### SUMMARY OF THE INVENTION

The present invention as defined in claim 2 provides a method of manufacturing a hybrid multijunction solar cell comprising providing a growth substrate; depositing on said growth substrate a sequence of layers of semiconductor material including group IV/III-V hybrid alloys forming a solar cell; and removing the semiconductor substrate.

In another aspect the present invention as defined in claim 13 provides a method of manufacturing a hybrid multijunction solar cell comprising providing a semiconductor growth substrate; depositing on said semiconductor growth substrate a sequence of layers of semiconductor material forming a solar cell, including at least one layer composed of GeSiSn and one layer grown over the GeSiSn layer composed of Ge; applying a metal contact layer over said sequence of layers; and applying a supporting member directly over said metal contact layer.

In another aspect the present invention provides a hybrid multijunction solar cell as defined in claim 1 including a first solar subcell composed of InGaP or InGaAlP and having a first band gap; a second solar subcell composed of GaAs, InGaAsP, or InGaP and disposed over the first solar subcell having a second band gap smaller than the first band gap and lattice matched to said first solar subcell; and a third solar subcell composed of GeSiSn and disposed over the second solar subcell and having a third band gap smaller than the second band gap and lattice matched with respect to the second subcell.

Additional aspects, advantages, and novel features of the present invention will become apparent to those skilled in the art from this disclosure, including the following detailed description as well as by practice of the invention. While the invention is described below with reference to preferred embodiments, it should be understood that the invention is not limited thereto. Those of ordinary skill in the art having access to the teachings herein will recognize additional applications, modifications and embodiments in other fields, which are within the scope of the invention as disclosed and claimed herein and with respect to which the invention could be of utility.

### BRIEF DESCRIPTION OF THE DRAWINGS

The invention will be better and more fully appreciated by reference to the following detailed description when considered in conjunction with the accompanying drawings, wherein:

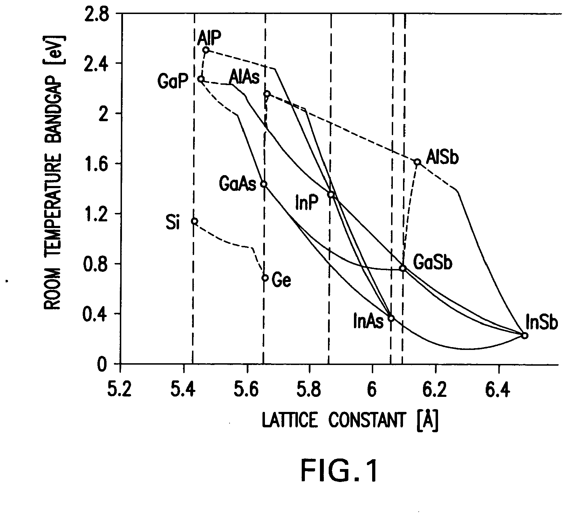

FIG. 1 is a graph representing the bandgap of certain binary materials and their lattice constants;
FIG. 2A is a cross-sectional view of a solar cell not covered by the invention after the deposition of semiconductor layers on the growth substrate; according to an example not being part of the present invention;
FIG. 2B is a cross-sectional view of a solar cell not covered by the invention after the deposition of semiconductor layers on the growth substrate; according to an example not being part of the present invention;
FIG. 2C is a cross-sectional view of the solar cell of the invention after the deposition of semiconductor layers on the growth substrate; according to an embodiment of the present invention;
FIG. 2D is a cross-sectional view of the solar cell of the invention after the deposition of semiconductor layers on the growth substrate; according to a further embodiment of the present invention;
FIG. 2E is a cross-sectional view of the solar cell of the invention after the deposition of semiconductor layers on the growth substrate; according to yet a further embodiment of the present invention;
FIG. 3 is a highly simplified cross-sectional view of the solar cell of FIG. 2 after the next process step of depositing a BSF layer over the "bottom" solar subcell;
FIG. 4 is a cross-sectional view of the solar cell of FIG. 3 after the next process step;
FIG. 5 is a cross-sectional view of the solar cell of FIG. 4 after the next process step in which a surrogate substrate is attached;
FIG. 6A is a cross-sectional view of the solar cell of FIG. 5 after the next process step in which the original substrate is removed;
FIG. 6B is another cross-sectional view of the solar cell of FIG. 6A with the surrogate substrate on the bottom of the Figure;
FIG. 7 is a cross-sectional view of the solar cell of FIG. 6B after the next process step;
FIG. 8 is a cross-sectional view of the solar cell of FIG. 7 after the next process step;
FIG. 9 is a cross-sectional view of the solar cell of FIG. 8 after the next process step;
FIG. 10A is a top plan view of a wafer in which four solar cells are fabricated;
FIG. 10B is a bottom plan view of the wafer of FIG. 10A;
FIG. 10C is a top plan view of a wafer in which two solar cells are fabricated;
FIG. 11 is a cross-sectional view of the solar cell of FIG. 9 after the next process step;
FIG. 12A is a cross-sectional view of the solar cell of FIG. 11 after the next process step;
FIG. 12B is a cross-sectional view of the solar cell of FIG. 12A after the next process step;
FIG. 13A is a top plan view of the wafer of FIG. 10A depicting the surface view of the trench etched around the cell, after the process step depicted in FIG. 12B;
FIG. 13B is a top plan view of the wafer of FIG. 10C depicting the surface view of the trench etched around the cell, after the process step depicted in FIG. 12B;
FIG. 14A is a cross-sectional view of the solar cell of FIG. 12B after the next process step in an embodiment of the present invention;
FIG. 14B is a cross-sectional view of the solar cell of FIG. 12B after the next process step in an embodiment of the present invention;
FIG. 14C is a cross-sectional view of the solar cell of FIG. 14A after the next process step of removal of the surrogate substrate;
Fig. 14D is a cross-sectional view of the solar cell of Fig. 14A after next process step in some embodiments of the present invention;
FIG. 15 is a cross-sectional view of the solar cell of FIG. 14B after the next process step in an embodiment of the present invention; and
FIG 16 is a graph of the doping profile in the base and emitter layers of a subcell in the solar cell according to the present invention.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

The basic concept of fabricating an inverted multijunction solar cell is to grow the subcells of the solar cell on a substrate in a "reverse" sequence. That is, the high band gap subcells (i.e. subcells with band gaps in the range of 1.8 to 2.1 eV), which would normally be the "top" subcells facing the solar radiation, are initially grown epitaxially directly on a semiconductor growth substrate, such as for example GaAs or Ge, and such subcells are consequently lattice matched to such substrate. One or more lower band gap middle subcells (i.e. with band gaps in the range of 1.2 to 1.8 eV) can then be grown on the high band gap subcells.

At least one lower subcell is formed over the middle subcell such that the at least one lower subcell is substantially lattice matched with respect to the growth substrate and such that the at least one lower subcell has a third lower band gap (i.e., a band gap in the range of 0.7 to 1.2 eV). A surrogate substrate or support structure is then attached or provided over the "bottom" or lower subcell, and the growth semiconductor substrate is subsequently removed. (The growth substrate may then subsequently be re-used for the growth of a second and subsequent solar cells).

A variety of different features and aspects of a type of inverted multijunction solar cell known as inverted metamorphic multijunction solar cells are disclosed in U.S. Patent Application Serial No. 12/401,189 and the related applications noted in that application. Some or all of such features may be included in the structures and processes associated with the solar cells of the present invention.

The lattice constants and electrical properties of the layers in the semiconductor structure are preferably controlled by specification of appropriate reactor growth temperatures and times, and by use of appropriate chemical composition and dopants. The use of a vapor deposition method, such as Organo Metallic Vapor Phase Epitaxy (OMVPE), Metal Organic Chemical Vapor Deposition (MOCVD), Molecular Beam Epitaxy (MBE), or other vapor deposition methods for the reverse growth may enable the layers in the monolithic semiconductor structure forming the cell to be grown with the required thickness, elemental composition, dopant concentration and grading and conductivity type.

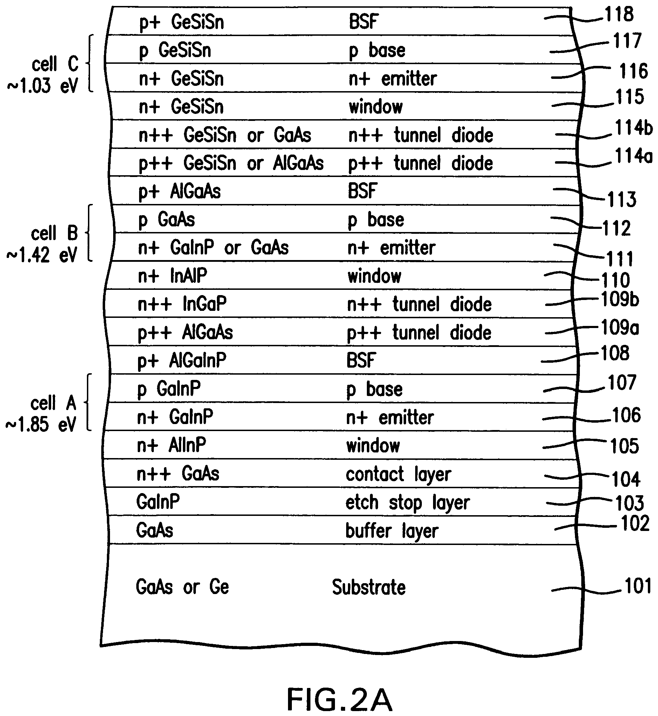

FIG. 2A depicts the multijunction solar cell according to an example not covered by the present invention after the sequential formation of the three subcells A, B, and C on a GaAs growth substrate. More particularly, there is shown a substrate 101, which is preferably gallium arsenide (GaAs), but may also be germanium (Ge) or other suitable material. For GaAs, the substrate is preferably a 15° off-cut substrate, that is to say, its surface is orientated 15° off the (100) plane towards the (111)A plane, as more fully described in U.S. Patent Application Serial No. 12/047,944, filed March 13, 2008. Other alternative growth substrates, such as described in U.S. Patent Application Serial No. 12/337,014 filed December 17, 2008, may be used as well

In the case of a Ge substrate, a nucleation layer (not shown) is deposited directly on the substrate 101. On the substrate, or over the nucleation layer (in the case of a Ge substrate), a buffer layer 102 and an etch stop layer 103 are further deposited. In the case of GaAs substrate, the buffer layer 102 is preferably GaAs. In the case of Ge substrate, the buffer layer 102 is preferably InGaAs. A contact layer 104 of GaAs is then deposited on layer 103, and a window layer 105 of n+ type AlInP is deposited on the contact layer. The subcell A, consisting of an n+ emitter layer 106 and a p-type base layer 107, is then epitaxially deposited on the window layer 105. The subcell A is generally latticed matched to the growth substrate 101.

It should be noted that the multijunction solar cell structure could be formed by any suitable combination of group III to V elements listed in the periodic table subject to lattice constant and bandgap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorus (P), arsenic (As), antimony (Sb), and bismuth (Bi).

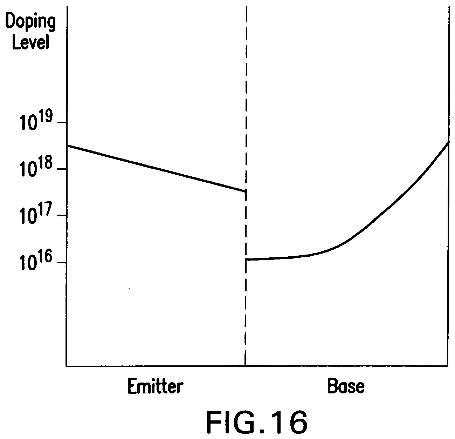

In one preferred embodiment, the emitter layer 106 is composed of InGa(A1)P and the base layer 107 is composed of InGa(Al)P. The aluminum or A1 term in parenthesis in the preceding formula means that A1 is an optional constituent, and in this instance in various embodiments of the invention may be used in an amount ranging from 0% to 30%. The doping profile of the emitter and base layers 106 and 107 according to one embodiment of the present invention will be discussed in conjunction with FIG. 16.

Subcell A will ultimately become the "top" subcell of the inverted multijunction structure after completion of the process steps according to the present invention to be described hereinafter.

On top of the base layer 107 a back surface field ("BSF") layer 108 preferably p+ AlGaInP is deposited and used to reduce recombination loss.

The BSF layer 108 drives minority carriers from the region near the base/BSF interface surface to minimize the effect of recombination loss. In other words, a BSF layer 108 reduces recombination loss at the backside of the solar subcell A and thereby reduces the recombination in the base.

On top of the BSF layer 108 is deposited a sequence of heavily doped p-type and n-type layers 109a and 109b that form a tunnel diode, i.e. an ohmic circuit element that connects subcell A to subcell B. Layer 109a is preferably composed of p++ AlGaAs, and layer 109b is preferably composed of n++ InGaP.

On top of the tunnel diode layers 109 a window layer 110 is deposited, preferably n+ InGaP, although other materials may be used as well. More generally, the window layer 110 used in the subcell B operates to reduce the interface recombination loss. It should be apparent to one skilled in the art, that additional layer(s) may be added or deleted in the cell structure without departing from the scope of the present invention.

On top of the window layer 110 the layers of subcell B are deposited: the n+ type emitter layer 111 and the p type base layer 112. These layers are preferably composed of InGaP and GaAs respectively (for a GaAs substrate), although any other suitable materials consistent with lattice constant and bandgap requirements may be used as well. Thus, in other embodiments subcell B may be composed of a GaAs, GaInP, GaInAs, GaAsSb, or GaInAsN emitter region and a GaAs, GaInAs, GaAsSb, or GaInAsN base region, respectively. The doping profile of layers 111 and 112 in various embodiments according to the present invention will be discussed in conjunction with FIG. 16.

In some embodiments of the present invention, similar to the structure disclosed in U.S. Patent Application Serial No. 12/023,772, the middle subcell may be a heterostructure with an InGaP emitter and its window is converted from InAlP to InGaP. This modification may eliminate the refractive index discontinuity at the window/emitter interface of the middle subcell. Moreover, in some embodiments the window layer 110 may be preferably doped more than that of the emitter 111 to move the Fermi level up closer to the conduction band and therefore create band bending at the window/emitter interface which results in constraining the minority carriers to the emitter layer.

In one of the preferred embodiments of the present invention, the middle subcell emitter has a band gap equal to the top subcell emitter, and the bottom subcell emitter has a band gap greater than the band gap of the base of the middle subcell. Therefore, after fabrication of the solar cell, and implementation and operation, neither the emitters of middle subcell B nor the bottom subcell C will be exposed to absorbable radiation.

Substantially all of the photons representing absorbable radiation will be absorbed in the bases of cells B and C, which have narrower band gaps than the emitters. Therefore, the advantages of using heterojunction subcells are: (i) the short wavelength response for both subcells will improve, and (ii) the bulk of the radiation is more effectively absorbed and collected in the narrower band gap base. The effect will be to increase the short circuit current J_{sc}.

Over the base layer 112 a BSF layer 113, preferably p+ type AlGaAs, is deposited. The BSF layer 113 performs the same function as the BSF layer 108.

The p++/n++ tunnel diode layers 114a and 114b respectively are deposited over the BSF layer 113, similar to the layers 109a/109b, forming an ohmic circuit element to connect subcell B to subcell C. The layer 114a is preferably composed of p++ GeSiSn, and layer 114b is preferably composed of n++ GeSiSn.

A window layer 115 preferably composed of n+ type GeSiSn is then deposited over the tunnel diode layer 114b. This window layer operates to reduce the recombination loss in subcell C. It should be apparent to one skilled in the art that additional layers may be added or deleted in the cell structure without departing from the scope of the present invention.

On top of the window layer 115, the layers of subcell C are deposited: the n+ emitter layer 116, and the p type base layer 117. These layers are preferably composed of n+ type GeSiSn and p type GeSiSn, respectively, or n+ type and p type for a heterojunction subcell, although other suitable materials consistent with lattice constant and bandgap requirements may be used as well. The formation of the junction in subcell C may be implemented by the diffusion of As and P into the GeSiSn layers. The doping profile of layers 116 and 117 will be discussed in connection with FIG. 16.

The band gaps of the sequence of solar subcells in the example are preferably approximately 1.85 eV for the top subcell A, 1.42 eV for subcell B, and 1.03 eV for subcell C.

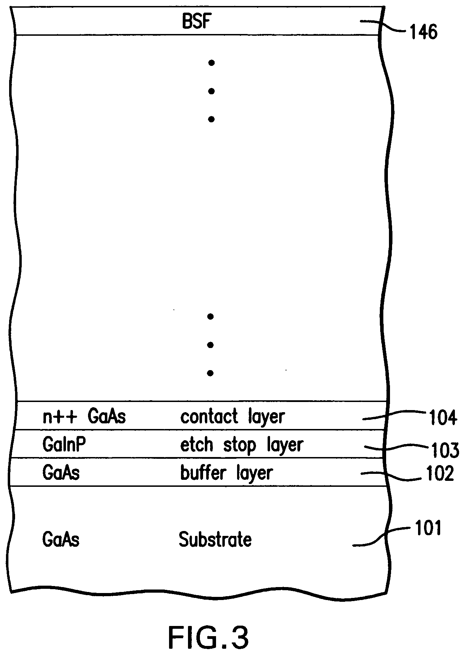

As will be discussed in connection with FIG. 3, a BSF layer, preferably composed of p+ type GeSiSn, may be deposited on top of the base layer 117 of subcell C, the BSF layer performing the same function as the BSF layers 108 and 113.

The description of subsequent processing steps in the fabrication of the solar cell in the embodiment of FIG. 2A will be described beginning with the description of FIG. 3 and subsequent Figures. Meanwhile, we will describe other embodiments of the multijunction solar cell semiconductor structure.

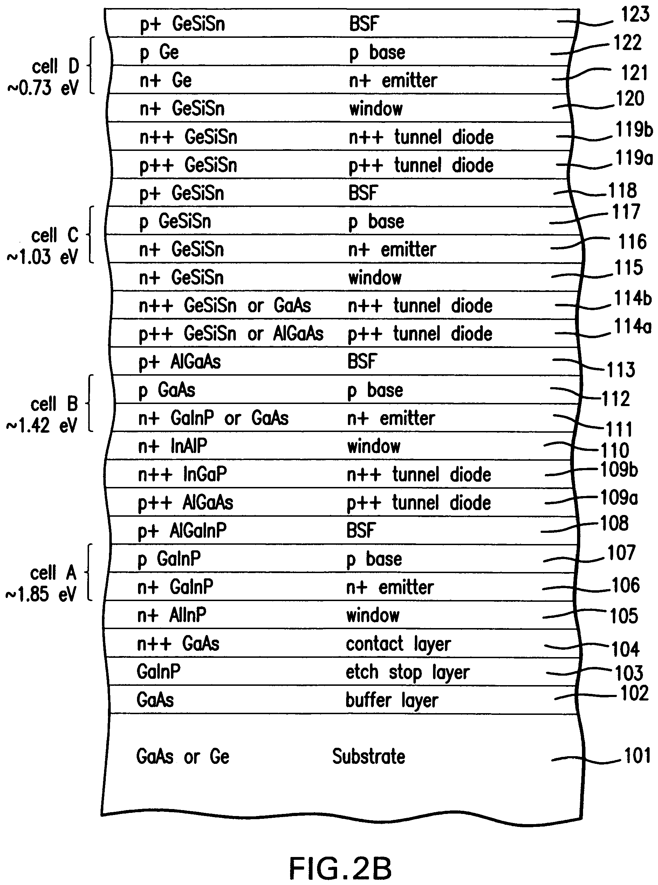

FIG. 2B depicts the multijunction solar cell according to an example not covered by the present invention after the sequential formation of the four subcells A, B, C, and D on a GaAs growth substrate. More particularly, there is shown a substrate 101, which is preferably gallium arsenide (GaAs), but may also be germanium (Ge) or other suitable material. For GaAs, the substrate is preferably a 15° off-cut substrate, that is to say, its surface is orientated 15° off the (100) plane towards the (111)A plane, as more fully described in U.S. Patent Application Serial No. 12/047,944, filed March 13, 2008. Other alternative growth substrates, such as described in U.S. Patent Application Serial No. 12/337,014 filed December 17, 2008, may be used as well.

The composition of layers 101 through 117 in the embodiment of FIG. 2B are similar to those described in the embodiment of FIG. 2A, but may have different elemental compositions or dopant concentrations, and will not be repeated here.

In the embodiment of FIG. 2B, a BSF layer 118, preferably composed of p+ type GeSiSn, is deposited on top of the base layer 117 of subcell C, the BSF layer performing the same function as the BSF layers 108 and 113.

The p++/n++ tunnel diode layers 119a and 119b respectively are deposited over the BSF layer 118, similar to the layers 109a/109b and 114a/114b, forming an ohmic circuit element to connect subcell C to subcell D. The layer 119a is preferably composed of p++ GeSiSn, and layer 119b is preferably composed of n++ GeSiSn.

A window layer 120 preferably composed of n+ type GeSiSn is then deposited over the tunnel diode layer 119b. This window layer operates to reduce the recombination loss in subcell D. It should be apparent to one skilled in the art that additional layers may be added or deleted in the cell structure without departing from the scope of the present invention.

On top of the window layer 120, the layers of subcell D are deposited: the n+ emitter layer 121, and the p type base layer 122. These layers are preferably composed of n+ type Ge and p type Ge, respectively, although other suitable materials consistent with lattice constant and bandgap requirements may be used as well. The formation of the junction in subcell C may be implemented by the diffusion of As and P into the GeSiSn layers. The doping profile of layers 121 and 122 in one embodiment will be discussed in connection with FIG. 16.

As will be discussed in connection with FIG. 3, a BSF layer 123, preferably composed of p+ type GeSiSn, is then deposited on top of the subcell D, the BSF layer performing the same function as the BSF layers 108, 113, and 118.

The band gaps of the sequence of solar subcells in the second embodiment are preferably approximately 1.85 eV for the top subcell A, 1.42 eV for subcell B, 1.03 eV for subcell C, and 0.73 eV for the top subcell D.

The description of subsequent processing steps in the fabrication of the solar cell in the embodiment of FIG. 2B will be described beginning with the description of FIG. 3 and subsequent Figures. Meanwhile, we will describe other embodiments of the multijunction solar cell semiconductor structure.

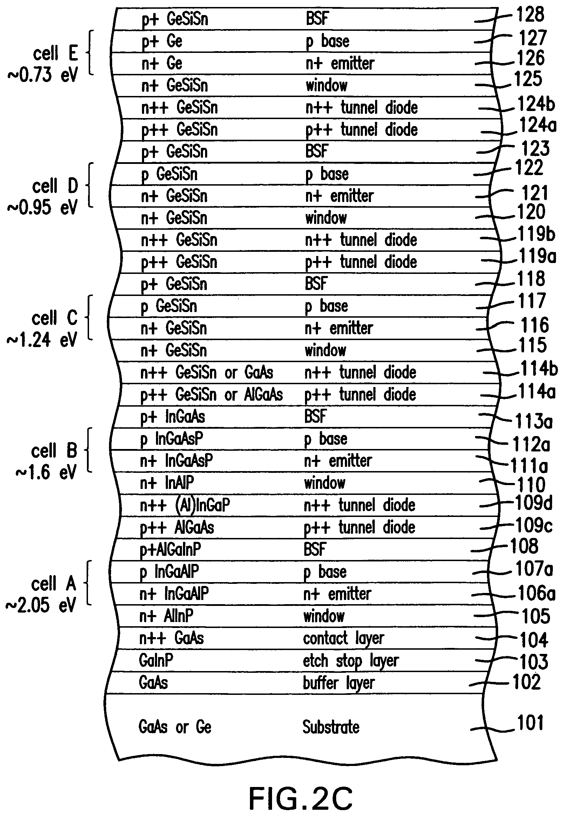

FIG. 2C depicts the multijunction solar cell according to another embodiment of the present invention after the sequential formation of the five subcells A, B C, D, and E on a GaAs growth substrate. More particularly, there is shown a substrate 101, which is preferably gallium arsenide (GaAs), but may also be germanium (Ge) or other suitable material.

The composition and description of the substrate 101 through layer 105, and the layers 114a through 123 are substantially similar to that described in connection with the embodiment of FIG. 2B, but with different elemental compositions or dopant concentrations to result in different band gaps, and need not be repeated here. In particular, in the embodiment of FIG. 2C, the band gap of subcell A may be approximately 2.05 eV, and the band gap of subcell B may be approximately 1.6 eV.

Turning to the embodiment depicted in FIG. 2C, on top of the window layer 105, the layers of subcell A are deposited: the n+ emitter layer 106a, and the p type base layer 107a. These layers are preferably composed of n+ type InGaAlP and p type InGaAlP, respectively, although other suitable materials consistent with lattice constant and bandgap requirements may be used as well. Subcell A preferably has a band gap of approximately 2.05 eV.

On top of the base layer 107a a back surface field ("BSF") layer 108 preferably p+ AlGaInP is deposited and used to reduce recombination loss.

The BSF layer 108 drives minority carriers from the region near the base/BSF interface surface to minimize the effect of recombination loss. In other words, a BSF layer 108 reduces recombination loss at the backside of the solar subcell A and thereby reduces the recombination in the base.

On top of the BSF layer 108 is deposited a sequence of heavily doped p-type and n-type layers 109c and 109d that form a tunnel diode, i.e. an ohmic circuit element that connects subcell A to subcell B. Layer 109c is preferably composed of p++ AlGaAs, and layer 109d is preferably composed of n++ (Al)InGaP.

On top of the tunnel diode layers 109c/109d a window layer 110 is deposited, preferably n+ InGaP, although other materials may be used as well. More generally, the window layer 110 used in the subcell B operates to reduce the interface recombination loss. It should be apparent to one skilled in the art, that additional layer(s) may be added or deleted in the cell structure without departing from the scope of the present invention.

On top of the window layer 110 the layers of subcell B are deposited: the n+ type emitter layer 111a and the p type base layer 112a. These layers are preferably composed of InGaAsP and InGaAsP respectively, although any other suitable materials consistent with lattice constant and bandgap requirements may be used as well. Subcell B preferably has a band gap of approximately 1.6 eV. The doping profile of the emitter and base layers in one embodiment will be discussed in connection with FIG. 16.

On top of the base layer 112a a back surface field ("BSF") layer 113a preferably p+ InGaAs is deposited and used to reduce recombination loss.

On top of the BSF layer 113a is deposited a sequence of heavily doped p-type and n-type layers 114a and 114b that form a tunnel diode The layers 114a through 123 are substantially similar to that described in connection with the embodiment of FIG. 2B, but with different elemental compositions or dopant concentrations to result in different band gaps. The band gaps of the sequence of solar subcells C and D in this embodiment are preferably approximately 1.24 eV for the subcell C, and 0.95 eV for subcell D.

On top of the base layer 122 of subcell D a back surface field ("BSF") layer 123 preferably p+ GeSiSn is deposited and used to reduce recombination loss.

On top of the BSF layer 123 is deposited a sequence of heavily doped p-type and n-type layers 124a and 124b that form a tunnel diode, i.e. an ohmic circuit element that connects subcell D to subcell E. Layer 124a is preferably composed of p++ GeSiSn, and layer 124b is preferably composed of n++ GeSiSn.

On top of the tunnel diode layers 124a/124b a window layer 125 is deposited, preferably n+ GeSiSn, although other materials may be used as well. More generally, the window layer 125 used in the subcell E operates to reduce the interface recombination loss. It should be apparent to one skilled in the art, that additional layer(s) may be added or deleted in the cell structure without departing from the scope of the present invention.

On top of the window layer 125 the layers of subcell E are deposited: the n+ type emitter layer 126 and the p type base layer 127. These layers are preferably composed of Ge, although any other suitable materials consistent with lattice constant and bandgap requirements may be used as well. The formation of the junction in subcell E may be implemented by the diffusion of As and P into the Ge layer. The doping profile of layers 126 and 127 in one embodiment will be discussed in connection with FIG. 16. Subcell E preferably has a band gap of approximately 0.73 eV.

As will be discussed in connection with FIG. 3, a BSF layer 128, preferably composed of p+ type GeSiSn, is then deposited on top of the subcell E, the BSF layer performing the same function as the BSF layers 108, 113a, 118, and 123.

The band gaps of the sequence of solar subcells in this embodiment are preferably approximately 2.05 eV for the top subcell A, 1.6 eV for subcell B, and 1.24 eV for subcell C, 0.95 eV for subcell D, and 0.73 eV for subcell E.

The description of subsequent processing steps in the fabrication of the solar cell in the embodiment of FIG. 2C will be described beginning with the description of FIG. 3 and subsequent Figures. Meanwhile, we will describe other embodiments of the multijunction solar cell semiconductor structure.

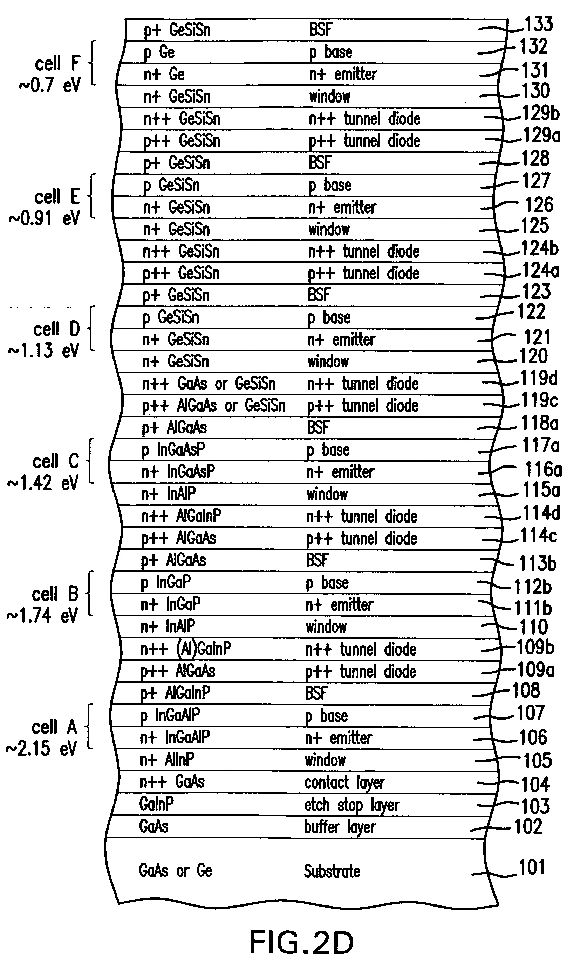

FIG. 2D depicts the multijunction solar cell according to another embodiment of the present invention after the sequential formation of the six subcells A, B, C, D, E and F on a GaAs growth substrate. More particularly, there is shown a substrate 101, which is preferably gallium arsenide (GaAs), but may also be germanium (Ge) or other suitable material.

The composition and description of the substrate 101 and the layers 102 through 110, and layers 120 through 128 are substantially similar to that described in connection with the embodiment of FIG. 2C, but with different elemental compositions or dopant concentrations to result in different band gaps, and need not be repeated here.

Turning to the embodiment depicted in FIG. 2D, on top of the window layer 110 the layers of subcell B are deposited: the n+ type emitter layer 111b and the p type base layer 112b. These layers are preferably composed of n+ type InGaP and p type InGaP respectively, although any other suitable materials consistent with lattice constant and bandgap requirements may be used as well. Subcell B preferably has a band gap of approximately 1.74 eV.

On top of the base layer 112b a back surface field ("BSF") layer 113b preferably p+ AlGaAs is deposited and used to reduce recombination loss.

On top of the BSF layer 113b is deposited a sequence of heavily doped p-type and n-type layers 114c and 114d that form a tunnel diode, i.e. an ohmic circuit element that connects subcell B to subcell C. Layer 114c is preferably composed of p++ AlGaAs and layer 114d is preferably composed of n++ AlGaInP.

On top of the tunnel diode layers 114c/114d a window layer 115a is deposited, preferably n+ InAlP, although other materials may be used as well. More generally, the window layer 115a used in the subcell C operates to reduce the interface recombination loss. It should be apparent to one skilled in the art, that additional layer(s) may be added or deleted in the cell structure without departing from the scope of the present invention.

On top of the window layer 115a the layers of subcell C are deposited: the n+ type emitter layer 116a and the p type base layer 117a. These layers are preferably composed of n+ type InGaAsP and p type InGaAsP respectively, although any other suitable materials consistent with lattice constant and bandgap requirements may be used as well. Subcell C preferably has a band gap of approximately 1.42 eV.

On top of the base layer 117a a back surface field ("BSF") layer 118a preferably p+ AlGaAs is deposited and used to reduce recombination loss.

On top of the BSF layer 118a is deposited a sequence of heavily doped p-type and n-type layers 119c and 119d that form a tunnel diode, i.e. an ohmic circuit element that connects subcell C to subcell D. Layer 119c is preferably composed of p++ AlGaAs or GeSiSn and layer 119d is preferably composed of n++ GaAs or GeSiSn.

On top of the tunnel diode layers 119c/119d a window layer 120 is deposited, preferably n+ GeSiSn, although other materials may be used as well. More generally, the window layer 120 used in the subcell D operates to reduce the interface recombination loss. It should be apparent to one skilled in the art, that additional layer(s) may be added or deleted in the cell structure without departing from the scope of the present invention. As noted above, layers 120 through 128 are substantially similar to that described in connection with the embodiment of FIG. 2C, but with different elemental compositions or dopant concentrations to result in different band gaps, and need not be repeated here. Thus, in this embodiment, subcell D preferably has a band gap of approximately 1.13 eV, and subcell E preferably has a band gap of approximately 0.91 eV.

On top of the BSF layer 128 composed of p type GeSiSn is deposited a sequence of heavily doped p-type and n-type layers 129a and 129b that form a tunnel diode, i.e. an ohmic circuit element that connects subcell E to subcell F. Layer 129a is preferably composed of p++ GeSiSn and layer 129b is preferably composed of n++ GeSiSn.

On top of the tunnel diode layers 129a/129b a window layer 130 is deposited, preferably n+ GeSiSn, although other materials may be used as well. More generally, the window layer 130 used in the subcell F operates to reduce the interface recombination loss. It should be apparent to one skilled in the art, that additional layer(s) may be added or deleted in the cell structure without departing from the scope of the present invention.

On top of the window layer 130 the layers of subcell F are deposited: the n+ type emitter layer 131 and the p type base layer 132. These layers are preferably composed of n+ type Ge and p type Ge respectively, although any other suitable materials consistent with lattice constant and bandgap requirements may be used as well. Subcell F preferably has a band gap of approximately 0.7 eV. The doping profile of the emitter and base layers in one embodiment will be discussed in connection with FIG. 16.

As will be discussed in connection with FIG. 3, a BSF layer 133, preferably composed of p+ type GeSiSn, is then deposited on top of the subcell F, the BSF layer performing the same function as the BSF layers 108, 113a, 118, 123, and 128.

The band gaps of the sequence of solar subcells in this embodiment are preferably approximately 2.15 eV for the top subcell A, 1.74 eV for subcell B, and 1.42 eV for subcell C, 1.13 eV for subcell D, 0.91 eV for subcell E, and 0.7 for subcell F.

The description of subsequent processing steps in the fabrication of the solar cell in the embodiment of FIG. 2D will be described beginning with the description of FIG. 3 and subsequent Figures. Meanwhile, we will describe one more embodiment of the multijunction solar cell semiconductor structure.

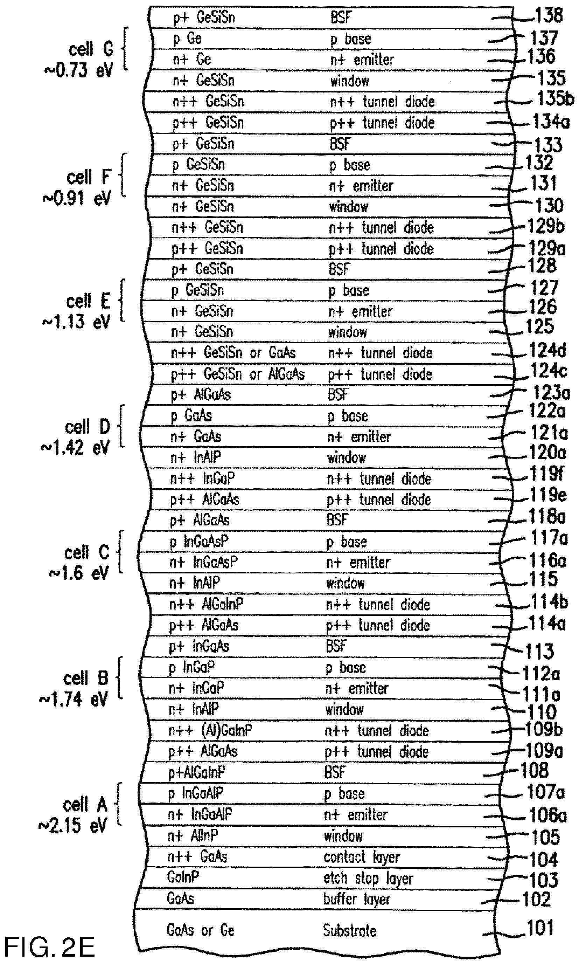

FIG. 2E depicts the multijunction solar cell according to another embodiment of the present invention after the sequential formation of the seven subcells A, B, C, D, E, F and G on a GaAs growth substrate. More particularly, there is shown a substrate 101, which is preferably gallium arsenide (GaAs), but may also be germanium (Ge) or other suitable material.

The composition and description of the substrate 101 and the layers 102 through 118a, and layers 125 through 133 are substantially similar to that described in connection with the embodiment of FIG. 2D, but with different elemental compositions or dopant concentrations to result in different band gaps, and need not be repeated here. In particular, in the embodiment of FIG. 2E, the band gap of subcell C may be approximately 1.6 eV, and in the sequence of layers 125 through 133, the band gap of subcell E may be approximately 1.13 eV, and the band gap of subcell F may be approximately 0.91 eV.

Turning to the embodiment depicted in FIG. 2E, on top of the BSF layer 118a composed of AlGaAs is deposited a sequence of heavily doped p-type and n-type layers 119e and 119f that form a tunnel diode, i.e. an ohmic circuit element that connects subcell C to subcell D. Layer 119e is preferably composed of p++ AlGaAs and layer 119f is preferably composed of n++ InGaP.

On top of the tunnel diode layers 119e/119f a window layer 120a is deposited, preferably n+ InAlP, although other materials may be used as well. More generally, the window layer 120a used in the subcell D operates to reduce the interface recombination loss. It should be apparent to one skilled in the art, that additional layer(s) may be added or deleted in the cell structure without departing from the scope of the present invention.

On top of the window layer 120a the layers of subcell D are deposited: the n+ type emitter layer 121a and the p type base layer 122a. These layers are preferably composed of n+ type GaAs and p type GaAs respectively, although any other suitable materials consistent with lattice constant and bandgap requirements may be used as well. Subcell D preferably has a band gap of approximately 1.42 eV.

On top of the base layer 122a a back surface field ("BSF") layer 123a preferably p+ AlGaAs is deposited and used to reduce recombination loss.

On top of the BSF layer 123a is deposited a sequence of heavily doped p-type and n-type layers 124c and 124d that form a tunnel diode, i.e. an ohmic circuit element that connects subcell D to subcell E. Layer 124c is preferably composed of p++ GeSiSn or AlGaAs, and layer 124d is preferably composed of n++ GeSiSn or GaAs.

On top of the tunnel diode layers 129d/129e a window layer 130 is deposited, composed of n+ type GeSiSn. As noted above, layers 125 through 133 are substantially similar to that described in connection with the embodiment of FIG. 2D, but with different elemental compositions or dopant concentrations to result in different band gaps, and need not be repeated here. Thus, in this embodiment, subcell E preferably has a band gap of approximately 1.13 eV, and subcell F preferably has a band gap of approximately 0.91 eV.

Turning again to the embodiment depicted in FIG. 2E, on top of the BSF layer 133 composed of GeSiSn is deposited a sequence of heavily doped p-type and n-type layers 134a and 134b that form a tunnel diode, i.e. an ohmic circuit element that connects subcell F to subcell G. Layer 134a is preferably composed of p++ GeSiSn and layer 134b is preferably composed of n++ GeSiSn.

On top of the tunnel diode layers 134a/134b a window layer 135 is deposited, preferably n+ GeSiSn, although other materials may be used as well. More generally, the window layer 135 used in the subcell G operates to reduce the interface recombination loss. It should be apparent to one skilled in the art, that additional layer(s) may be added or deleted in the cell structure without departing from the scope of the present invention.

On top of the window layer 135 the layers of subcell G are deposited: the n+ type emitter layer 136 and the p type base layer 137. These layers are preferably composed of n+ type GeSiSn and p type GeSiSn respectively, although any other suitable materials consistent with lattice constant and bandgap requirements may be used as well. Subcell G preferably has a band gap of approximately 0.73 eV. The doping profile of the emitter and base layers in one embodiment will be discussed in connection with FIG. 16.

FIG. 3 is a highly simplified cross-sectional view of the solar cell structure of any of the embodiments of FIGs. 2A, 2B, 2C, 2D or 2E, depicting the top BSF layer of the solar cell structure, relabeled in this FIG. 3 and subsequent Figures, as BSF layer 146 deposited over the base layer of the last deposited subcell. The BSF layer 146 therefore represents the BSF layer 118, 123, 128, 133, or 138 depicted and described in connection with FIG. 2A, 2B, 2C, 2D, or 2E respectively.

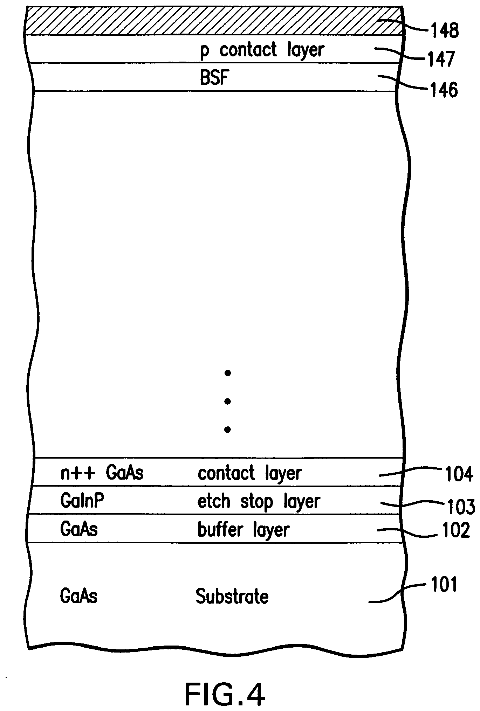

FIG. 4 is a cross-sectional view of the solar cell of FIG. 3 after the next process step in which a high band gap contact layer 147, preferably composed of a suitable p++ type material, is deposited on the BSF layer 146. This contact layer 147 deposited on the bottom (non-illuminated) side of the lowest band gap photovoltaic subcell, in a multijunction photovoltaic cell, can be suitably formulated to reduce absorption of the light that passes through the cell, so that (i) a subsequently deposited ohmic metal contact layer below (*i.e*. towards the non-illuminated side) the contact layer will also act as a mirror layer, and (ii) the contact layer doesn't have to be selectively etched off, to prevent absorption in the layer.

It should be apparent to one skilled in the art, that additional layer(s) may be added or deleted in the cell structure without departing from the scope of the present invention.

FIG. 4 further depicts the next process step in which a metal contact layer 148 is deposited over the p++ semiconductor contact layer 147. The metal is preferably the sequence of metal layers Ti/Au/Ag/Au or Ti/Pd/Ag, although other suitable sequences and materials may be used as well.

The metal contact scheme chosen is one that has a planar interface with the semiconductor, after heat treatment to activate the ohmic contact. This is done so that (i) a dielectric layer separating the metal from the semiconductor doesn't have to be deposited and selectively etched in the metal contact areas; and (ii) the contact layer is specularly reflective over the wavelength range of interest.

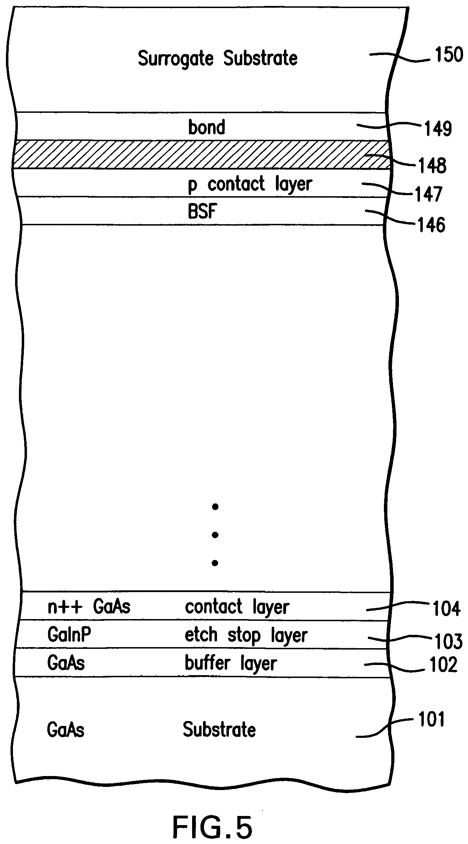

FIG. 5 is a cross-sectional view of the solar cell of FIG. 4 after the next process step in which a bonding layer 149 is deposited over the metal contact layer 148. In one embodiment of the present invention, the bonding layer 149 is an adhesive, preferably Wafer Bond (manufactured by Brewer Science, Inc. of Rolla, MO.), although other suitable bonding materials may be used.

In the next process step, a surrogate substrate 150, preferably sapphire, is attached over the bonding layer. Alternatively, the surrogate substrate may be GaAs, Ge or Si, or other suitable material. The surrogate substrate 150 is preferably about 1.016 mm (40 mils) in thickness, and in the case of embodiments in which the surrogate substrate is to be removed, it is perforated with holes about 1 mm in diameter, spaced 4 mm apart, to aid in subsequent removal of the adhesive and the substrate.

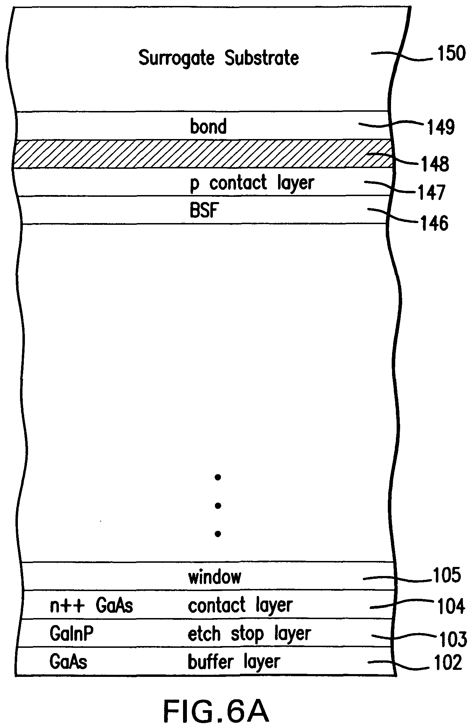

FIG. 6A is a cross-sectional view of the solar cell of FIG. 5 after the next process step in which the original substrate is removed by a sequence of lapping, grinding and/or etching steps in which the substrate 101, and the buffer layer 102 are removed. The choice of a particular etchant is growth substrate dependent. In some embodiments, the substrate 101 may be removed by an epitaxial lift-off process, such as described in U.S. Patent Application Serial No. 12/367,991, filed February 9, 2009.

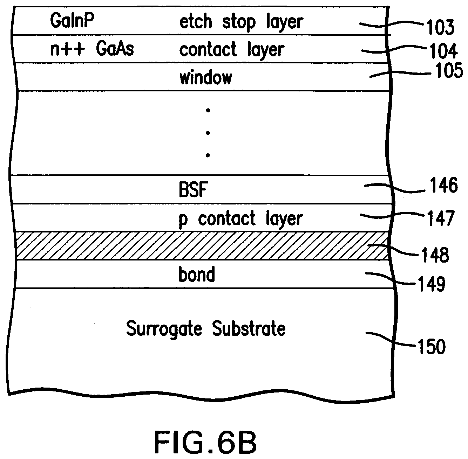

FIG. 6B is a cross-sectional view of the solar cell of FIG. 6A with the orientation with the surrogate substrate 150 being at the bottom of the Figure. Subsequent Figures in this application will assume such orientation.

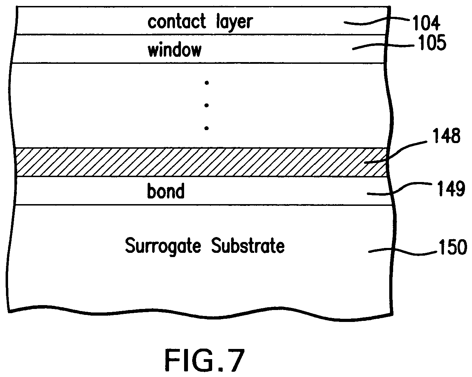

FIG. 7 is a cross-sectional view of the solar cell of FIG. 6B after the next process step in which the etch stop layer 103 is removed by a HCl/H₂O solution.

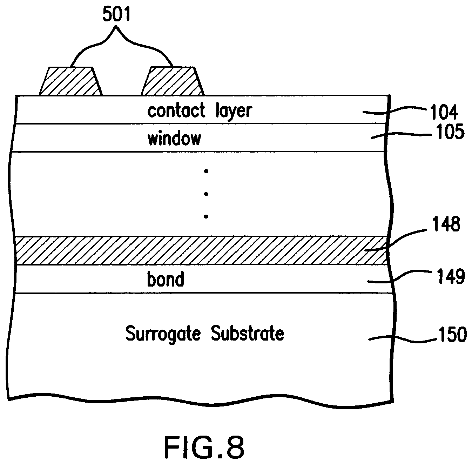

FIG. 8 is a cross-sectional view of the solar cell of FIG. 7 after the next sequence of process steps in which a photoresist layer (not shown) is placed over the semiconductor contact layer 104. The photoresist layer is lithographically patterned with a mask to form the locations of the grid lines 501, portions of the photoresist layer where the grid lines are to be formed are removed, and a metal contact layer is then deposited by evaporation or similar processes over both the photoresist layer and into the openings in the photoresist layer where the grid lines are to be formed. The photoresist layer portion covering the contact layer 104 is then lifted off to leave the finished metal grid lines 501, as depicted in the Figure. As more fully described in U.S. Patent Application Serial No. 12/218,582 filed July 18, 2008, the grid lines 501 are preferably composed of the sequence of layers Pd/Ge/Ti/Pd/Au, although other suitable sequences and materials may be used as well.

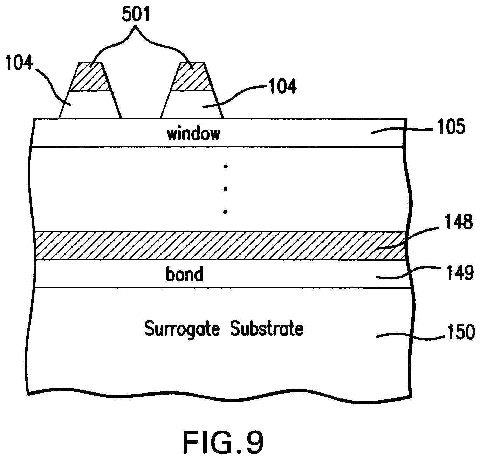

FIG. 9 is a cross-sectional view of the solar cell of FIG. 8 after the next process step in which the grid lines 501 are used as a mask to etch down the surface to the window layer 105 using a citric acid/peroxide etching mixture.

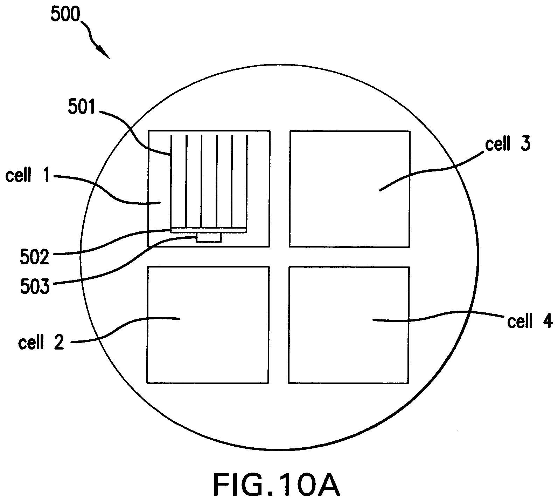

FIG. 10A is a top plan view of a 100 mm (or 4 inch) wafer in which four solar cells are implemented. The depiction of four cells is for illustration for purposes only, and the present invention is not limited to any specific number of cells per wafer.

In each cell there are grid lines 501 (more particularly shown in cross-section in FIG. 9), an interconnecting bus line 502, and a contact pad 503. The geometry and number of grid and bus lines and contact pads are illustrative, and the present invention is not limited to the illustrated embodiment.

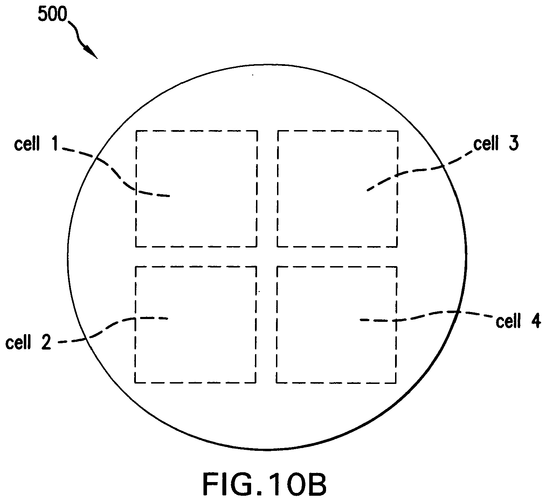

FIG. 10B is a bottom plan view of the wafer of FIG. 10A.

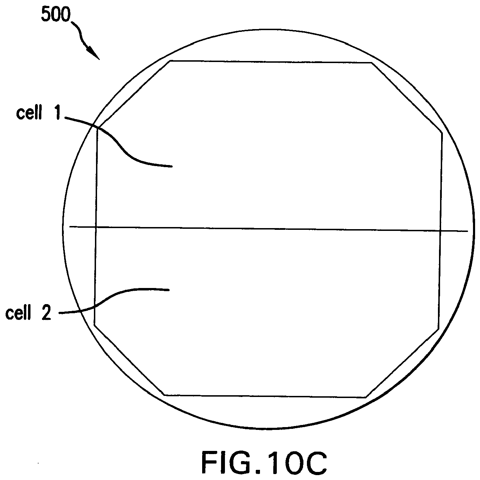

FIG. 10C is a top plan view of a 100 mm (or 4 inch) wafer in which two solar cells are implemented. In some embodiments, each solar cell has an area of approximately 26.3 cm².

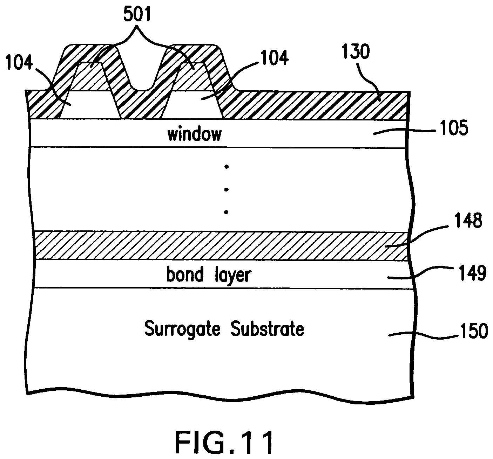

FIG. 11 is a cross-sectional view of the solar cell of FIG. 9 after the next process step in which an antireflective (ARC) dielectric coating layer 160 is applied over the entire surface of the "top" side of the wafer with the grid lines 501.

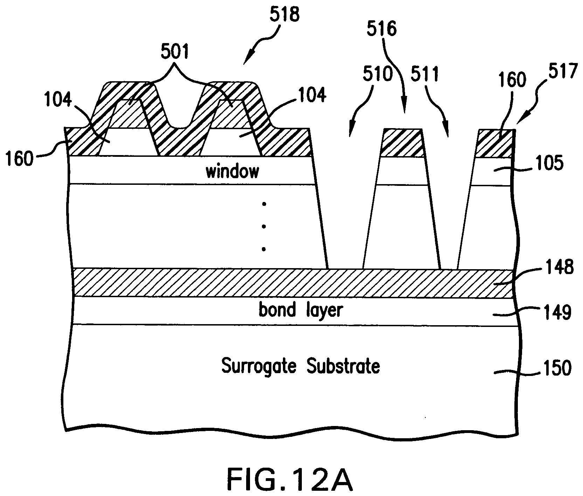

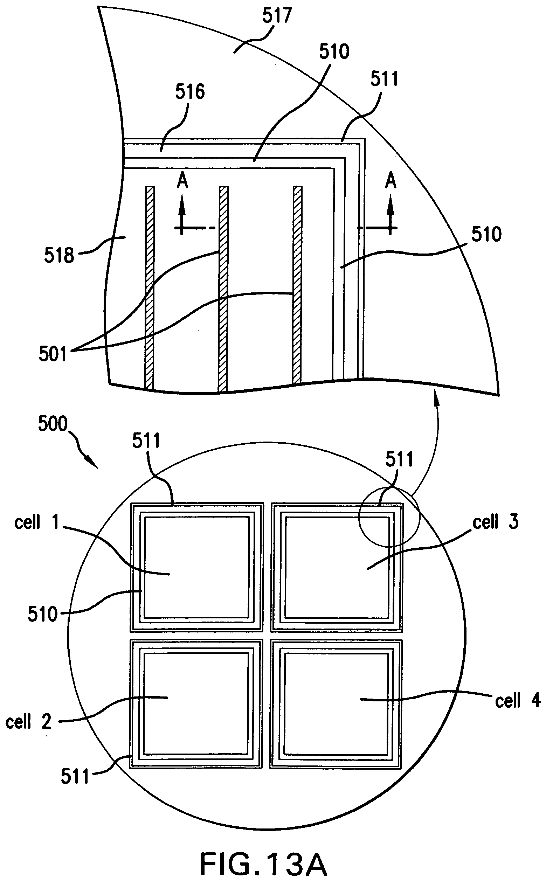

FIG. 12A is a cross-sectional view of the solar cell of FIG. 11 after the next process step according to the present invention in which first and second annular channels 510 and 511, or portions of the semiconductor structure, are etched down to the metal layer 148 using phosphide and arsenide etchants. These channels, as more particularly described in U.S. Patent Application Serial No. 12/190,449 filed August 12, 2008, define a peripheral boundary between the cell, a surrounding mesa 516, and a periphery mesa 517 at the edge of the wafer, and leave a mesa structure 518 which constitutes the solar cell. The cross-section depicted in FIG 12A is that as seen from the A-A plane shown in FIG. 13A.

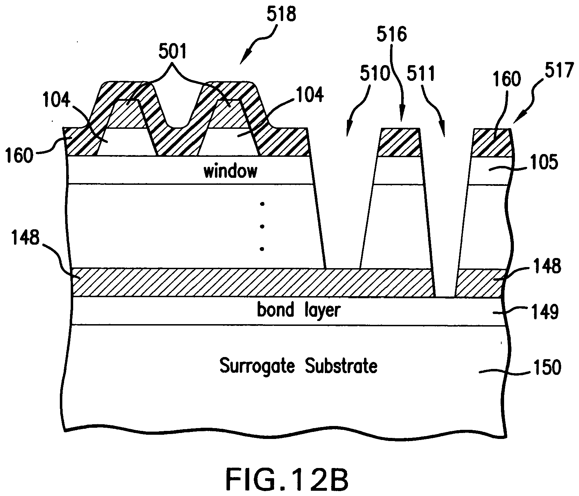

FIG. 12B is a cross-sectional view of the solar cell of FIG. 12A after the next process step in which channel 511 is exposed to a metal etchant, layer 123 in the channel 511 is removed, and channel 511 is extended in depth approximately to the top surface of the bond layer 149.

FIG 13A is a top plan view of the wafer of FIG. 10A depicting the channels 510 and 511 etched around the periphery of each cell.

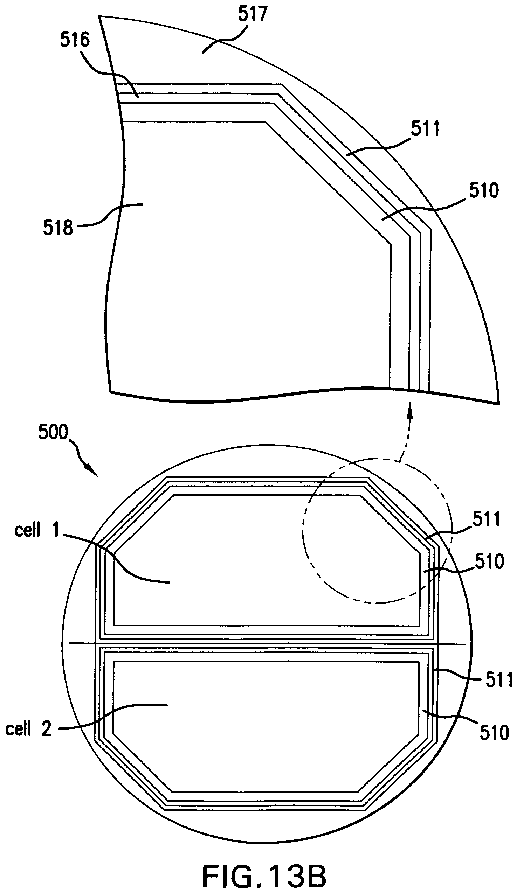

FIG 13B is a top plan view of the wafer of FIG. 10C depicting the channels 510 and 511 etched around the periphery of each cell.

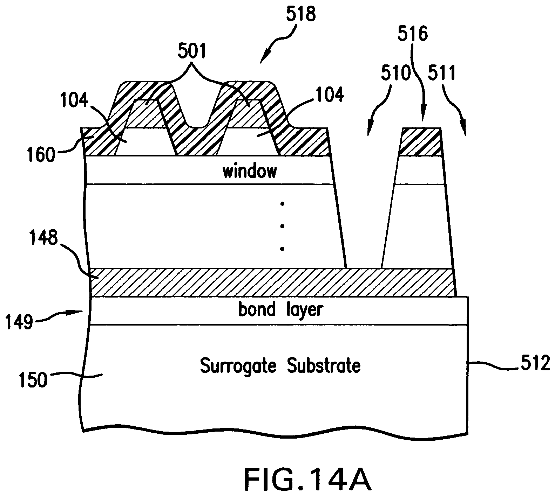

FIG. 14A is a cross-sectional view of the solar cell of FIG. 12B after the individual solar cells (cell 1, cell 2, etc. shown in FIG. 13) are cut or scribed from the wafer through the channel 511, leaving a vertical edge 512 extending through the surrogate substrate 150. In this embodiment of the present invention, the surrogate substrate 150 forms the support for the solar cell in applications where a cover glass (such as provided in a further embodiment to be described below) is not required. In an embodiment, electrical contact to the metal contact layer 148 may be made through the channel 510.

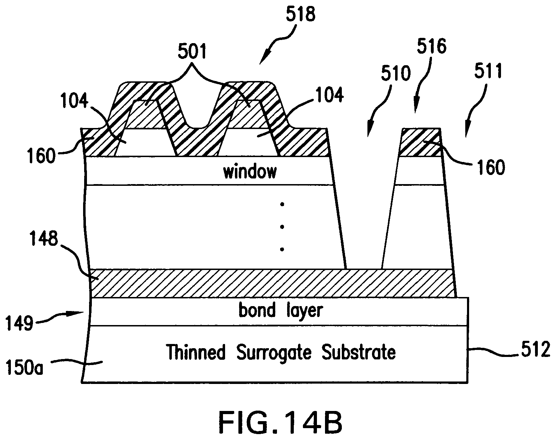

FIG. 14B is a cross-sectional view of the solar cell of FIG. 12B after the next process step in a further embodiment of the present invention in which the surrogate substrate 150 is appropriately thinned to a relatively thin layer 150a, by grinding, lapping, or etching. The individual solar cells (cell 1, cell 2, etc. shown in FIG. 13A) are cut or scribed from the wafer through the channel 511, leaving a vertical edge 515 extending through the surrogate substrate 150a. In this embodiment, the thin layer 150a forms the support for the solar cell in applications where a cover glass, such as provided in a yet further embodiment to be described below, is not required. In an embodiment, electrical contact to the metal contact layer 148 may be made through the channel 510.

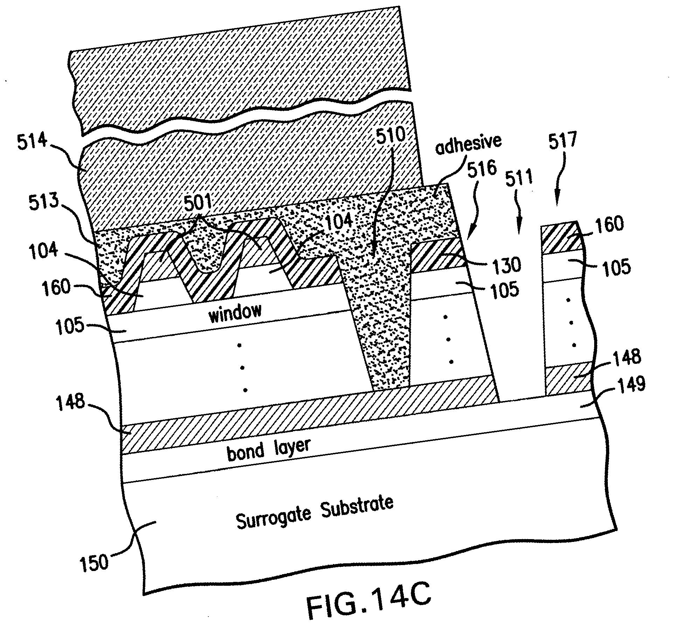

FIG. 14C is a cross-sectional view of the solar cell of FIG. 12B after the next process step in a further embodiment of the present invention in which a cover glass 514 is secured to the top of the cell by an adhesive 513. The cover glass 514 is typically about 0.1016 mm (4 mils) thick and preferably covers the entire channel 510, extends over a portion of the mesa 516, but does not extend to channel 511. Although the use of a cover glass is desirable for many environmental conditions and applications, it is not necessary for all implementations, and additional layers or structures may also be utilized for providing additional support or environmental protection to the solar cell.

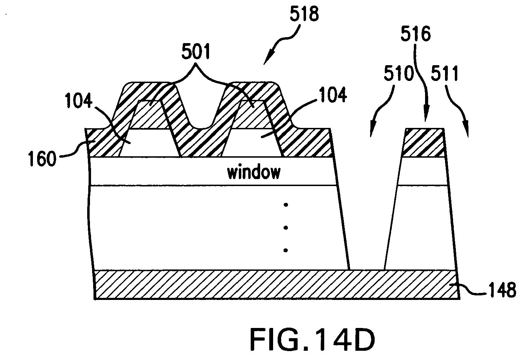

FIG. 14D is a cross-sectional view of the solar cell of FIG. 14A after the next process step in some embodiments of the present invention in which the bond layer, the surrogate substrate 150 and the peripheral portion 517 of the wafer are entirely removed, leaving only the solar cell with the ARC layer 160 (or other layers or structures) on the top, and the metal contact layer 148 on the bottom, wherein the metal contact layer 148 forms the backside contact of the solar cell. The surrogate substrate is preferably removed by the use of a 'Wafer Bond' solvent. As noted above, the surrogate substrate includes perforations over its surface that allow the flow of solvent through the perforations in the surrogate substrate 150 to permit its lift off. After lift off, the surrogate substrate may be reused in subsequent wafer processing operations.

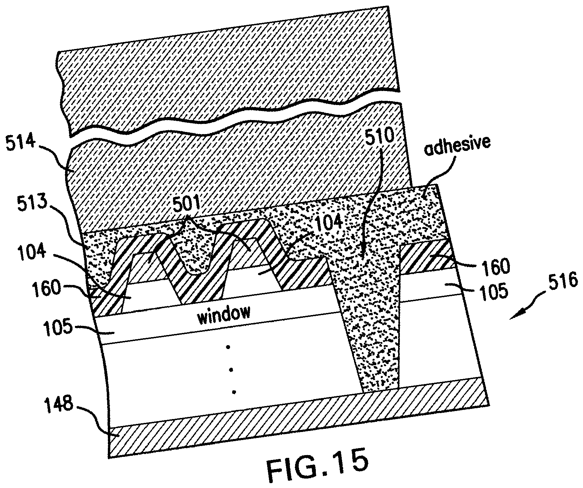

FIG. 15 is a cross-sectional view of the solar cell of FIG. 14C after the next process step in some embodiments of the present invention in which the bond layer 124, the surrogate substrate 150 and the peripheral portion 517 of the wafer is entirely removed, leaving only the solar cell with the cover glass 514 (or other layers or structures) on the top, and the layer on the bottom. The surrogate substrate is preferably removed by the use of a 'Wafer Bond' solvent. As noted above, the surrogate substrate includes perforations over its surface that allow the flow of solvent through the surrogate substrate 150 to permit its lift off. After lift off, the surrogate substrate may be reused in subsequent wafer processing operations.

FIG. 16 is a graph of a doping profile in the emitter and base layers in one or more subcells of the inverted metamorphic multijunction solar cell of the present invention. The various doping profiles within the scope of the present invention, and the advantages of such doping profiles are more particularly described in copending U.S. Patent Application Serial No. 11/956,069 filed December 13, 2007. The doping profiles depicted herein are merely illustrative, and other more complex profiles may be utilized as would be apparent to those skilled in the art without departing from the scope of the present invention.

It will be understood that each of the elements described above, or two or more together, also may find a useful application in other types of constructions differing from the types of constructions described above.

In addition, although the present embodiment is configured with top and bottom electrical contacts, the subcells may alternatively be contacted by means of metal contacts to laterally conductive semiconductor layers between the subcells. Such arrangements may be used to form 3-terminal, 4-terminal, and in general, n-terminal devices. The subcells can be interconnected in circuits using these additional terminals such that most of the available photogenerated current density in each subcell can be used effectively, leading to high efficiency for the multijunction cell, notwithstanding that the photogenerated current densities are typically different in the various subcells.

As noted above, the present invention may utilize an arrangement of one or more, or all, homojunction cells or subcells, i.e., a cell or subcell in which the p-n junction is formed between a p-type semiconductor and an n-type semiconductor both of which have the same chemical composition and the same band gap, differing only in the dopant species and types, and one or more heterojunction cells or subcells. Subcell A, with p-type and n-type InGaP is one example of a homojunction subcell. Alternatively, as more particularly described in U.S. Patent Application Serial No. 12/023,772 filed January 31, 2008, the present invention may utilize one or more, or all, heterojunction cells or subcells, i.e., a cell or subcell in which the p-n junction is formed between a p-type semiconductor and an n-type semiconductor having different chemical compositions of the semiconductor material in the n-type regions, and/or different band gap energies in the p-type regions, in addition to utilizing different dopant species and type in the p-type and n-type regions that form the p-n junction.

In some cells, a thin so-called "intrinsic layer" may be placed between the emitter layer and base layer, with the same or different composition from either the emitter or the base layer. The intrinsic layer may function to suppress minority-carrier recombination in the space-charge region. Similarly, either the base layer or the emitter layer may also be intrinsic or not-intentionally-doped ("NID") over part or all of its thickness. Some such configurations are more particularly described in copending U.S. Patent Application Serial No. 12/253,051, filed October 16, 2008.

The composition of the window or BSF layers may utilize other semiconductor compounds, subject to lattice constant and band gap requirements, and may include AlInP, AlAs, AlP, AlGaInP, AlGaAsP, AlGaInAs, AlGaInPAs, GaInP, GaInAs, GaInPAs, AlGaAs, AlInAs, AlInPAs, GaAsSb, AlAsSb, GaAlAsSb, AlInSb, GaInSb, AlGaInSb, AIN, GaN, InN, GaInN, AlGaInN, GaInNAs, AlGaInNAs, ZnSSe, CdSSe, and similar materials.

## Claims

1. A hybrid multijunction solar cell having a sequence of layers comprising:
a first solar subcell (A) composed of InGaP or InGaAlP and having a first band gap;
a second solar subcell (B) composed of GaAs, InGaAsP, or InGaP and disposed over the first solar subcell (A) having a second band gap smaller than the first band gap and lattice matched to said first solar subcell (A); and
a third solar subcell (C) having an emitter (116) and base layer (117) composed of GeSiSn and disposed over the second solar subcell (B) having a third band gap smaller than the second band gap and lattice matched with respect to the second subcell (B),
wherein, the sequence of layers includes a fourth subcell (D) composed of GeSiSn having a band gap in the range of 0.91 eV to 0.95 eV, and the third subcell (C) having a band gap in the range of 1.13 eV to 1.24 eV.

2. A method of manufacturing a hybrid multijunction solar cell with the features of claim 1 comprising:
providing a semiconductor growth substrate (101);
depositing on said semiconductor growth substrate (101) the sequence of layers of semiconductor material forming the solar cell, including the subcell having an emitter (116) and base layer (117) composed of a group IV alloy; and
removing the semiconductor growth substrate (101).

3. A method as defined in claim 2, wherein said step of depositing a sequence of layers of semiconductor material includes forming a first solar subcell (A) on said substrate having a first band gap; forming a second solar subcell (B) over said first subcell (A) having a second band gap smaller than said first band gap; and forming a third solar subcell (C) over said second solar subcell (B) having a third band gap smaller than said second band gap, and preferably further comprising forming a fourth solar subcell (D) having a fourth band gap smaller than said third band gap that is lattice matched to said third solar subcell (C).

4. A method as defined in claim 3, further comprising forming a fifth solar subcell (E) over said fourth solar subcell having a fifth band gap smaller than said fourth band gap and preferably further comprising forming a sixth solar subcell (F) over said fifth solar subcell (E) having a sixth band gap smaller than said fifth band gap.

5. A method as defined in claim 4, further comprising forming a seventh solar subcell (G) over said sixth solar subcell (F) having a seventh band gap smaller than said sixth band gap.

6. A method as defined in claim 2, further comprising applying a bonding layer (149) over the sequence of layers of semiconductor material and attaching a surrogate substrate (150) to the bonding layer, and wherein the semiconductor substrate (101) is removed after the surrogate substrate (150) has been attached by grinding, etching, or epitaxial lift-off.

7. A method as defined in claim 2, wherein said semiconductor growth substrate (101) is selected from the group consisting of GaAs and Ge.

8. A method as defined in claim 3, wherein said solar cell is a hybrid solar cell and said first solar subcell is composed of an InGa(Al)P emitter region and an InGa(Al)P base region; said second solar subcell is composed of GaAs, InGaAsP, or InGaP; and said third solar subcell is composed of GeSiSn, InGaP, or GaAs.

9. A method as defined in claim 3, wherein said fourth solar subcell is composed of Ge, GeSiSn, or GaAs.

10. A method as defined in claim 4, wherein said fifth solar subcell is composed of Ge or GeSiSn.

11. A method as defined in claim 2, wherein a junction is formed in the group IV alloy to form a photovoltaic subcell by the diffusion of As and/or P into the group IV alloy layer.

12. A method as defined in claim 2, further comprising forming window (115, 120, 125, 130, 135) and BSF layers (118, 123, 128, 133, 138, 146) composed of a group IV alloy adjacent to the subcell composed of the group IV alloy.

13. A method of manufacturing a hybrid multijunction solar cell with the features of claim 1 comprising:
providing a semiconductor growth substrate (101);
depositing on said semiconductor growth substrate (101) a sequence of layers of semiconductor material forming a solar cell, including at least one layer composed of GeSiSn and one layer grown over the GeSiSn layer composed of Ge;
applying a metal contact layer (148) over said sequence of layers; and
applying a supporting member directly over said metal contact layer (148).

## Patentansprüche

1. Hybride Mehrfach-Solarzelle mit einer Sequenz von Schichten, enthaltend:
eine erste Solar-Unterzelle (A), zusammengesetzt aus InGaP oder InGaAlP und
aufweisend eine erste Bandlücke;
eine zweite Solar-Unterzelle (B), zusammengesetzt aus GaAs, InGaAsP oder InGaP und angeordnet auf der ersten Solar-Unterzelle (A), aufweisend eine zweite Bandlücke, die kleiner als die erste Bandlücke und gitterangepasst an besagte erste Solar-Unterzelle (A) ist; und
eine dritte Solar-Unterzelle (C), aufweisend eine Emitter- (116) und Basisschicht (117), zusammengesetzt aus GeSiSn und angeordnet auf der zweiten Solar-Unterzelle (B), aufweisend eine dritte Bandlücke, die kleiner als die zweite Bandlücke und gitterangepasst in Bezug auf die zweite Unterzelle (B) ist,
wobei die Sequenz von Schichten eine vierte Unterzelle (D) umfasst, zusammengesetzt aus GeSiSn, aufweisend eine Bandlücke im Bereich von 0,91 eV bis 0,95 eV, und wobei die dritte Unterzelle (C) eine Bandlücke im Bereich von 1,13 eV bis 1,24 eV aufweist.

2. Verfahren zur Herstellung einer hybriden Mehrfach-Solarzelle mit den Merkmalen des Anspruchs 1, enthaltend:
Bereitstellen eines Halbleiterwachstumssubstrats (101);
Abscheiden auf besagtem Halbleiterwachstumssubstrat (101) die Sequenz der Schichten aus Halbleitermaterial, die die Solarzelle bildet, umfassend die Unterzelle, aufweisend eine Emitter- (116) und Basisschicht (117), zusammengesetzt aus einer Legierung der Gruppe IV; und
Entfernen des Halbleiterwachstumssubstrats (101).

3. Verfahren gemäß Anspruch 2, wobei besagter Schritt des Abscheidens einer Sequenz von Schichten aus Halbleitermaterial Bilden einer ersten Solar-Unterzelle (A) auf besagtem Substrat, aufweisend eine erste Bandlücke; Bilden einer zweiten Solar-Unterzelle (B) auf besagter ersten Unterzelle (A), aufweisend eine zweite Bandlücke, die kleiner ist als die erste Bandlücke; und Bilden einer dritten Solar-Unterzelle (C) auf besagter zweiten Solar-Unterzelle (B) einschließt, aufweisend eine dritte Bandlücke, die kleiner ist als besagte zweite Bandlücke, und vorzugsweise weiterhin enthaltend Bilden einer vierten Solar-Unterzelle (D), die eine vierte Bandlücke aufweist, die kleiner ist als besagte dritte Bandlücke, die an besagte dritte Solar-Unterzelle gitterangepasst ist.

4. Verfahren gemäß Anspruch 3, weiterhin enthaltend Bilden einer fünften Solar-Unterzelle (E) auf besagter vierten Solar-Unterzelle, aufweisend eine fünfte Bandlücke, die kleiner ist als besagte vierte Bandlücke, und vorzugsweise weiterhin enthaltend eine sechste Solar-Unterzelle (F) auf besagter fünften Solar-Unterzelle (E), aufweisend eine sechste Bandlücke, die kleiner ist als besagte fünfte Bandlücke.

5. Verfahren gemäß Anspruch 4, weiterhin enthaltend eine siebte Solar-Unterzelle (G) auf besagter sechsten Solar-Unterzelle (F), aufweisend eine siebte Bandlücke, die kleiner ist als besagte sechste Bandlücke.

6. Verfahren gemäß Anspruch 2, weiterhin enthaltend Auftragen einer Klebeschicht (149) auf die Sequenz von Schichten aus Halbleitermaterial und Anbringen eines Ersatzsubstrats (150) an die Klebeschicht, und wobei das Halbleitersubstrat (101) entfernt wird, nachdem das Ersatzsubstrat (150) durch Schleifen, Ätzen oder epitaxiales Abheben angebracht wurde.

7. Verfahren gemäß Anspruch 2, wobei das Halbleiterwachstumssubstrat (101) aus der Gruppe ausgewählt wird, bestehend aus GaAs und Ge.

8. Verfahren gemäß Anspruch 3, wobei besagte Solarzelle eine Hybrid-Solarzelle ist und besagte erste Solar-Unterzelle zusammengesetzt ist aus einem InGa(Al)P Emitterbereich und einem InGa(Al)P Basisbereich; besagte zweite Solar-Unterzelle zusammengesetzt ist aus GaAs, InGaAsP oder InGaP; und besagte dritte Solar-Unterzelle zusammengesetzt ist aus GeSiSn, InGaP oder GaAs.

9. Verfahren gemäß Anspruch 3, wobei besagte vierte Solar-Unterzelle aus Ge, GeSiSn oder GaAs zusammengesetzt ist.

10. Verfahren gemäß Anspruch 4, wobei besagte fünfte Solar-Unterzelle aus Ge oder GeSiSn zusammengesetzt ist.

11. Verfahren gemäß Anspruch 2, wobei eine Verbindung in der Legierung der Gruppe IV gebildet wird, um eine Photovoltaik-Unterzelle durch die Diffusion von As und/oder P in die Legierungsschicht der Gruppe IV zu bilden.

12. Verfahren gemäß Anspruch 2, weiterhin enthaltend Bilden von Fenster- (115, 120, 125, 130, 135) und BSF-Schichten (118, 123, 128, 133, 138, 146), zusammengesetzt aus einer Legierung der Gruppe IV angrenzend zu der Unterzelle, zusammengesetzt aus der Legierung IV.

13. Verfahren zur Herstellung einer hybriden Mehrfach-Solarzelle mit den Merkmalen des Anspruchs 1, enthaltend:
Bereitstellen eines Halbleiterwachstumssubstrats (101);
Abscheiden auf diesem Halbleiterwachstumssubstrat (101) eine Sequenz von Schichten aus Halbleitermaterial, die eine Solarzelle bilden, einschließlich mindestens einer Schicht, zusammengesetzt aus GeSiSn, und einer Schicht, die auf der GeSiSn-Schicht gewachsen ist, die zusammengesetzt ist aus Ge;
Aufbringen einer Metallkontaktschicht (148) auf besagter Sequenz von Schichten; und
Aufbringen eines Trägerelements direkt auf besagter Metallkontaktschicht (148).

## Revendications

1. Une cellule solaire multijonction hybride ayant une séquence de couches comprenant :
une première sous-cellule solaire (A) composée d'InGaP ou d'InGaAlP et ayant une première bande interdite;
une deuxième sous-cellule solaire (B) composée de GaAs, InGaAsP ou InGaP et disposée sur la première sous-cellule solaire (A), ayant une deuxième bande interdite plus petite que la première bande interdite et adaptée au réseau de ladite première sous-cellule solaire (A); et
une troisième sous-cellule solaire (C) ayant une couche émetteur (116) et de base (117) composée de GeSiSn et disposée sur la deuxième sous-cellule solaire (B), ayant une troisième bande interdite plus petite que la deuxième bande interdite et adapté au réseau par rapport à la deuxième sous-cellule (B),
dans laquelle la séquence des couches comprend une quatrième sous-cellule (D) composée de GeSiSn, ayant un bande interdite dans la gamme de 0,91 eV à 0,95 eV, et dans laquelle la troisième sous-cellule (C) a une bande interdite dans la gamme de 1,13 eV à 1,24 eV.

2. Un procédé de fabrication d'une cellule solaire avec les caractéristiques de la revendication 1, comprenant :
fournir un substrat de croissance de semi-conducteur (101);
déposer sur ledit substrat de croissance de semi-conducteur (101) la séquence des couches en matériau semi-conducteur formant la cellule solaire, y compris la sous-cellule ayant une couche émetteur (116) et de base (117) composée d'un alliage de groupe IV; et
enlever le substrat de croissance de semi-conducteur (101).

3. Un procédé selon la revendication 2, dans lequel ladite étape de déposer une séquence de couches en matériau semi-conducteur comprend la formation d'une première sous-cellule solaire (A) sur ledit substrat, ayant une première bande interdite; la formation d'une deuxième sous-cellule solaire (B) sur ladite première sous-cellule (A), ayant une deuxième bande interdite plus petite que ladite première bande interdite; et la formation d'une troisième sous-cellule solaire (C) sur ladite deuxième sous-cellule solaire (B), ayant une troisième bande interdite plus petite que ladite deuxième bande interdite, et comprenant de préférence en outre la formation d'une quatrième sous-cellule solaire (D) qui a une quatrième bande interdite plus petite que ladite troisième bande interdite, qui est adaptée au réseau de ladite troisième sous-cellule solaire (C).

4. Un procédé selon la revendication 3, comprenant en outre la formation d'une cinquième sous-cellule solaire (E) sur ladite quatrième sous-cellule solaire ayant une cinquième bande interdite plus petite que ladite quatrième bande interdite, et comprenant de préférence en outre la formation d'une sixième sous-cellule solaire (F) sur ladite cinquième sous-cellule solaire (E) ayant une sixième bande interdite plus petite que ladite cinquième bande interdite.

5. Un procédé selon la revendication 4, comprenant en outre la formation d'une septième sous-cellule solaire (G) sur ladite sixième sous-cellule solaire (F) ayant une septième bande interdite plus petite que ladite sixième bande interdite.

6. Un procédé selon la revendication 2, comprenant en outre l'application d'une couche de liaison (149) sur la séquence des couches en matériau semi-conducteur et l'attachement d'un substrat de substitution (150) à la couche de liaison, et dans lequel le substrat semi-conducteur (101) est enlevé après que le substrat de substitution (150) a été attaché par broyage, gravure, ou décollage épitaxique.

7. Un procédé selon la revendication 2, dans lequel ledit substrat de croissance de semi-conducteur (101) est choisi à partir du groupe consistant en GaAs et Ge.

8. Un Procédé selon la revendication 3, dans lequel ladite cellule solaire est une cellule solaire hybride et ladite première sous-cellule solaire est composée d'une région émetteur d'InGa(Al)P et d'une région de base d'InGa(Al)P; ladite deuxième sous-cellule solaire est composée de GaAs, InGaAsP ou InGaP; et ladite troisième sous-cellule solaire est composée de GeSiSn, InGaP ouGaAs.

9. Un Procédé selon la revendication 3, dans lequel ladite quatrième sous-cellule solaire est composée de Ge, GeSiSn ou GaAs.

10. Un Procédé selon la revendication 4, dans lequel ladite cinquième sous-cellule solaire est composée de Ge ou GeSiSn.

11. Un procédé selon la revendication 2, dans lequel une jonction est formée dans l'alliage du groupe IV pour former une sous-cellule photovoltaïque par la diffusion de As et/ou P dans la couche d'alliage du groupe IV .

12. Un procédé selon la revendication 2, comprenant en outre la formation des couches de fenêtre (115, 120, 125, 130, 135) et de BSF (118, 123, 128, 133, 138, 146) composées d'un alliage du groupe IV adjacent à la sous-cellule composée de l'alliage du groupe IV.

13. Un Procédé de fabrication d'une cellule solaire multijonction hybride ayant les caractéristiques de la revendication 1, comprenant :
fournir un substrat de croissance de semi-conducteur (101);
déposer sur ledit substrat de croissance de semi-conducteur (101) une séquence de couches de matériau semi-conducteur formant une cellule solaire, y compris au moins une couche composée de GeSiSn et une couche cultivée sur la couche GeSiSn, composée de Ge;
appliquer une couche de contact métallique (148) sur cette séquence de couches;
appliquer un membre de soutien directement sur ladite couche de contact métallique (148).
